(19) Europäisches Patentamt European Patent Office Office européen des brevets

(11) EP 3 419 171 A1

(12) **EUROPEAN PATENT APPLICATION**

(43) Date of publication:
26.12.2018 Bulletin 2018/52

(51) Int Cl.:
H03K 17/567 (2006.01)    H03K 17/082 (2006.01)
H03K 17/18 (2006.01)

(21) Application number: 18179338.1

(22) Date of filing: 22.06.2018

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 23.06.2017  IN 201721022140
25.08.2017  GB 201713661

(71) Applicant: Nidec Control Techniques Limited
Newtown, Powys SY16 3BE (GB)

(72) Inventor: RAUT, Dilesh Arvind
410507 Pune Maharasahtra (IN)

(74) Representative: Jarrett, Daniel Phillip et al
Kilburn & Strode LLP
Lacon London
84 Theobalds Road
London WC1X 8NL (GB)

(54)  **METHOD AND APPARATUS FOR MONITORING A SEMICONDUCTOR SWITCH**

(57)  A method performed in a circuit is provided. The circuit comprises a semiconductor switch having first, second and third terminals and being arranged such that a signal applied at the first terminal controls a current between the second and third terminals. The circuit further comprises monitoring circuitry comprising a first diode and charge determining circuitry, the third terminal of the semiconductor switch being connected to the monitoring circuitry and to supply circuitry. The method comprises determining, by the charge determining circuitry, an indication of an amount of electrical charge that has, consequent to a switching event at the semiconductor switch, flown through the first diode under reverse recovery conditions.

Fig. 2

## Description

### Field

The present disclosure relates generally to a method and apparatus for monitoring a semiconductor switch.

### Background

Semiconductor switches are commonly used in conjunction with power electronics including switched-mode power supplies; inverters; Direct Current (DC), Alternating Current (AC), or servo drives; and DC-DC converters.

When a semiconductor switch is operated, switching and conduction losses occur. As a result of these losses, the junction temperature of the semiconductor switch increases. Such a temperature increase may impact the reliability of operation of the semiconductor switch.

### Summary

Aspects of the present disclosure are defined in the accompanying independent claims.

### Brief description of the drawings

Examples of the present disclosure will now be explained with reference to the accompanying drawings in which:

Fig. 1 shows a change in a voltage between a collector terminal and an emitter terminal of a semiconductor switch as a function of time when the switch is turned off;

Fig. 2 shows a circuit diagram of a circuit described herein;

Fig. 3 shows an example of the circuit described herein;

Fig. 4 shows a change in peak voltage across a capacitor of a circuit described herein as a function of a rise time of a semiconductor switch;

Fig. 5 shows a change in a voltage between a collector terminal and an emitter terminal of a semiconductor switch, and a change in a voltage across a capacitor, as a function of time when the switch is turned off; and

Figs. 6 to 8 show further examples of the circuit described herein.

Throughout the description and the drawings, like reference numerals refer to like parts.

### Detailed description

In overview, there is provided herein a method of monitoring a junction temperature of a semiconductor switch and/or a rise time of a voltage between the collector/drain terminal and the emitter/source terminal of a semiconductor switch consequent to the semiconductor switch being turned off. The method uses monitoring circuitry including a diode coupled, directly or indirectly, to the collector/drain terminal of the switch, and the method comprises determining an amount of charge that has flown through the diode consequent to the switch being turned off. The diode's cathode is electrically closer to the collector/drain terminal than its anode. As a diode only conducts in the reverse direction for a limited period of time, the reverse recovery time, when the switch is turned off, current only flows through the first diode for the reverse recovery time. As a result, the faster the voltage between the collector/drain terminal and the emitter/source terminal rises, the more charge will flow through the diode. The amount of charge that has flown through the diode consequent to the switch being switched off is thus indicative of the rise time of the voltage between the collector/drain terminal and the emitter/source terminal of a semiconductor switch, which is in turn indicative of the junction temperature of the semiconductor switch.

When a semiconductor switch, such as an insulated-gate bipolar transistor (IGBT), turns off in response to a signal applied at its first terminal (eg, its gate terminal), the voltage $v_{CE}$ between its second and third terminals (eg, its emitter and collector terminals) takes a finite amount of time to change to its peak value, known as the rise time. The rise time may be the time taken for the voltage $v_{CE}$ to change from a specified low value to a specified high value, eg, the time taken for the voltage $v_{CE}$ to rise from 10% to 90% of its peak value.

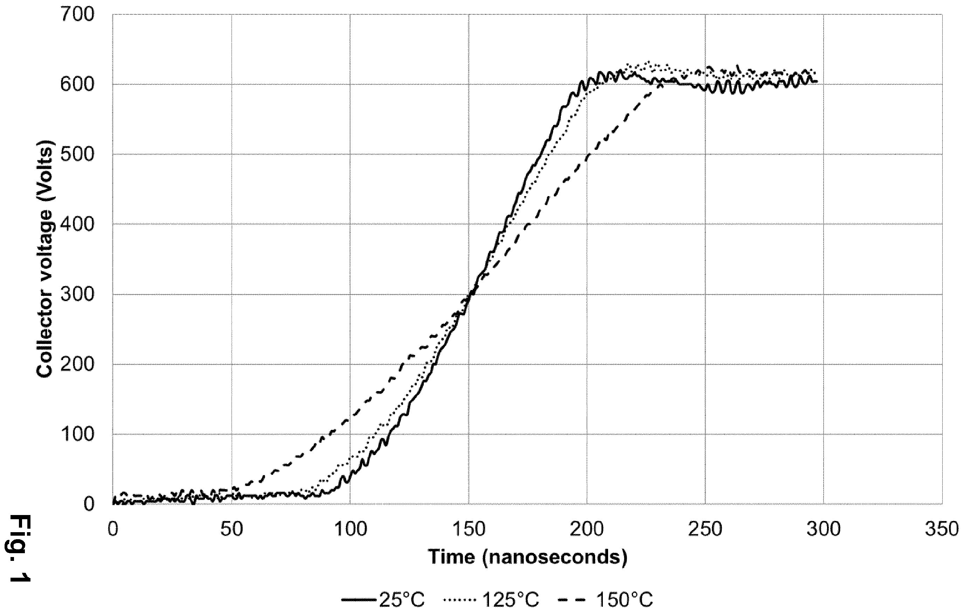

The rise time $t_{rise}$ of the voltage $v_{CE}$ between the second and third terminals of the switch will increase with the switch's junction temperature, ie, the switch reacts more slowly as its junction temperature increases. Fig. 1 illustrates this phenomenon for an IKQ75N120 IGBT, and shows a change in the voltage $v_{CE}$ (in Volts) as a function of time (in nanoseconds). The voltage $v_{CE}$ is shown for three different junction temperatures: 25 degrees Celsius, 125 degrees Celsius and 150 degrees Celsius. It can be seen that the rise time $t_{rise}$ of the voltage $v_{CE}$ increases with temperature; in other words, the rise time $t_{rise}$ of the voltage $v_{CE}$ is a measure that is indicative of the junction temperature of the switch.

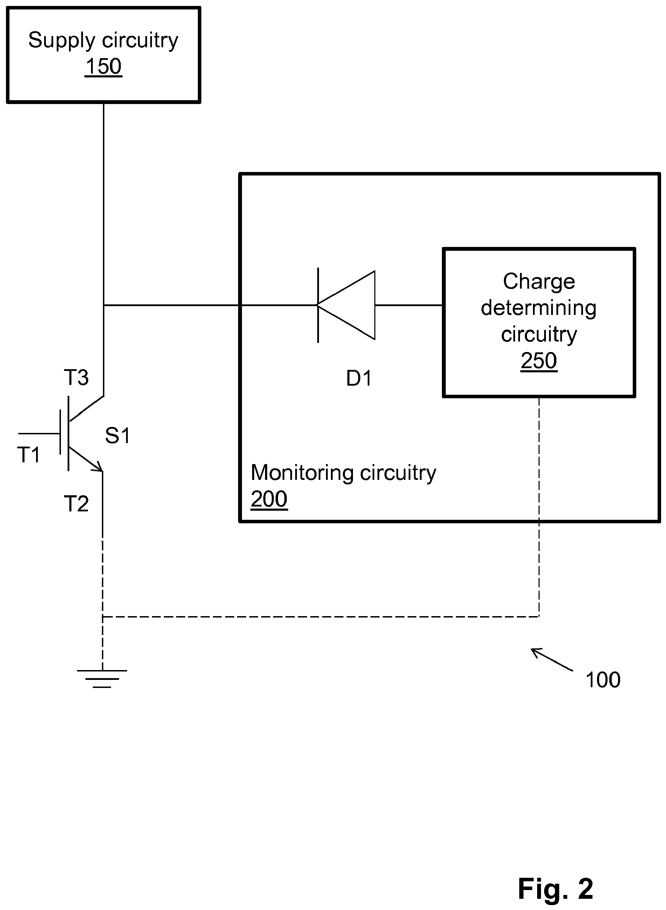

Fig. 2 shows a circuit 100 that can be used to monitor, determine, or estimate, the junction temperature of the switch and/or the rise time $t_{rise}$ of the voltage $v_{CE}$. The circuit comprises a semiconductor switch (or 'transistor', or 'electronic switch', or simply 'switch') S1, and monitoring circuitry (or 'determining circuitry', or 'tracking circuitry') 200.

The semiconductor switch S1 has first, second and third terminals T1, T2, and T3 arranged such that a signal applied at the first terminal T1 controls a current between the second and third terminals T2 and T3. In one example, a voltage may be applied between the first and second terminals T1 and T2 to control a current between the second and third terminals T2 and T3. In another example, a current may be applied at the first terminal T1 to control a current between the second and third terminals T2 and T3.

The semiconductor switch may be a transistor. In particular, the semiconductor switch may be an insulated-gate bipolar transistor (IGBT). In that case, the first, second and third terminals T1, T2, and T3 are respectively referred to as the gate, emitter and collector terminals.

The third terminal T3 is arranged to be connected to supply circuitry 150. The supply circuitry 150 is for supplying electrical energy to the switch S1. The supply circuitry 150 may comprise a voltage source (such as a battery) and/or a current source, and may further comprise a resistance and/or a capacitance.

The third terminal T3 is also connected (or directly or indirectly coupled) to the monitoring circuitry 200. The monitoring circuitry 200 is for monitoring the semiconductor switch S1. The monitoring circuitry 200 comprises a first diode D1 and charge determining circuitry 250. The first diode D1 is arranged such that its cathode is electrically closer to the third terminal T3 than its anode. In the example of Fig. 2, the first diode D1 is connected directly to the third terminal T3 of the switch S1, although it will be shown below that this need not be the case.

The monitoring circuitry 200 and/or the charge determining circuitry 250 are arranged to determine an indication of an amount of electrical charge that has, consequent to a switching event (eg, the switch S1 being switched off) at the semiconductor switch S1, flown through the first diode under reverse recovery conditions. As will be seen below, the charge determining circuitry 250 need not actually determine the amount of electrical charge, but may merely determine an indication thereof.

The monitoring circuitry 200 operates as follows. Consequent to a switching event, such as the switch S1 being turned off, the voltage $v_{CE}$ rises, causing current to flow from the supply circuitry 150 through the monitoring circuitry 200. Although a diode ideally has zero resistance to current in one direction, the forward direction, and infinite resistance in the other, the reverse direction, in practice, following the end of conduction in the forward direction, a reverse current can flow for a short time, usually measured in nanoseconds, known as the reverse recovery time $t_{rr}$. Such a current flow is referred to as a 'reverse recovery current', and occurs under 'reverse recovery conditions'. Consequent to the switching event, a current therefore flows through the first diode D1, from its cathode to its anode.

For a given reverse recovery time $t_{rr}$, the faster the voltage $v_{CE}$ rises, the more electrical charge will flow through the first diode D1 in the limited period of time $t_{rr}$. By determining the amount of electrical charge that has flown through the first diode D1 consequent to the switching event, an indication of (or a measure of), the rise time $t_{rise}$ of the voltage $v_{CE}$ can therefore be determined.

The reverse recovery time $t_{rr}$ of the chosen diode may impact the performance of the monitoring circuitry 200. If the reverse recovery time $t_{rr}$ is too long, eg, significantly longer than the rise time $t_{rise}$, then the same amount of charge may flow through the first diode D1 during the reverse recovery time $t_{rr}$, regardless of the rise time $t_{rise}$. On the other hand, if the reverse recovery time $t_{rr}$ is too short, there may be little difference in the amount of charge that flows through the first diode D1 during the reverse recovery time $t_{rr}$ even as the rise time $t_{rise}$ varies.

Thus, the reverse recovery time $t_{rr}$ may be chosen based on the rise time $t_{rise}$ of the switch S1. In particular, in one example, the first diode D1 may be chosen to have a reverse recovery time $t_{rr}$ that is equal, or substantially equal, to the rise time $t_{rise}$ of the switch S1 - preferably the rise time $t_{rise}$ of the switch S1 under normal operating conditions. In another example, the first diode D1 may be chosen to have a reverse recovery time $t_{rr}$ that is sufficient to allow the electrical charge to flow through the first diode under reverse recovery conditions until at least an end of the switching event - preferably the end of the switching event under normal operating conditions. The end of the switching event may be defined as the voltage $v_{CE}$ reaching a steady state, or the voltage $v_{CE}$ reaching a given proportion (eg, 50% or 90%) of its peak value.

Normal operating conditions may be defined as the switch S1 being operated at a junction temperature that is equal, or substantially equal, to the ambient temperature (eg, the switch S1 being operated at a junction temperature that is equal, or substantially equal, to 25 degrees Celsius). In this way, under normal operating conditions, when the rise time $t_{rise}$ is relatively short, the reverse recovery time $t_{rr}$ is sufficient to allow charge to flow until the end of the switching event. As the junction temperature of the switch S1 increases, the rise time $t_{rise}$ increases, and the reverse recovery time $t_{rr}$ then becomes insufficient to allow charge to flow until the end of the switching event, and therefore a smaller amount of charge flows through the first diode D1.

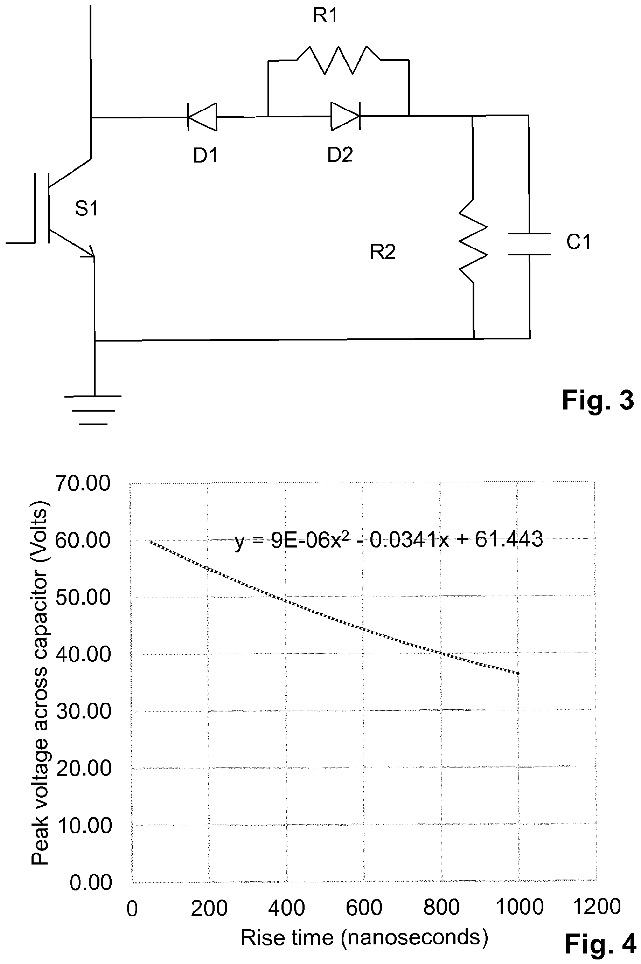

The charge determining circuitry 250 may comprise a capacitance. In one example, illustrated in Fig. 3, the indication of the electrical charge that has flown through the first diode D1 is provided by connecting a first capacitance, eg, capacitor C1, in series with first diode D1 and electrically farther from the third terminal T3 than the first diode D1. The charge that has flown through the first diode D1 can then be determined by determining the voltage across the capacitance, assuming the capacitance has been at least partially discharged prior to the switching event.

Fig. 4 shows a change in the peak voltage $v_{C1max}$ (in Volts) across the capacitor C1 as a function of the rise time $t_{rise}$ (in nanoseconds) of the voltage $v_{CE}$. It can be seen that the longer the rise time $t_{rise}$, the lower the peak voltage $v_{C1max}$ across the capacitor C1. The peak voltage $v_{C1max}$ across the capacitor C1 can be expressed as a function of the rise time $t_{rise}$ using a polynomial expression. In the example illustrated in Fig. 4, this expression is given by

$$v_{C1max} = 9 \cdot 10^{-6} \cdot t_{rise}^{2} - 0.0341 \cdot t_{rise} + 61.443.$$

Following the switching event, during which the capacitance is charged by means of a current flowing from the supply circuitry 150 to the cathode of the first diode D1 and then to the anode of the first diode D1, the capacitance may be discharged by means of a current flowing in the opposite direction - the forward direction of the first diode D1 - ie, from the capacitance to the anode of the first diode D1 and then to the cathode of the first diode D1. The capacitance is then at least partially discharged, ready for another switching event.

A flow of current from the capacitance towards the third terminal T3 of the semiconductor switch D1 may be fully or partially inhibited, hindered, limited, suppressed, or prevented. As a result, the discharging of the capacitance when the switch S1 turns back on may be reduced or controlled.

In one example, such as the example illustrated in Fig. 3, the inhibiting is performed a second diode D2 between the capacitance and the third terminal T3 of the switch S1, and in series with the first diode D1. The second diode D2 has its anode electrically closer to the third terminal T3 than its cathode, that is, it is arranged in the opposite direction to the first diode D1. In the example of Fig. 3, the second diode D2 is directly connected between the capacitor C1 and the first diode D1, although this need not be the case.

When the inhibiting is performed by a second diode D2, the second diode D2 may be exposed to lower voltages than the first diode D1, and may thus have a lower voltage rating than the first diode D1, thereby reducing the cost of the second diode D2.

In another example, such as the example illustrated in Fig. 3, the inhibiting is also (or instead) performed by a resistance, such as resistor R1, between the capacitance and the third terminal T3 of the semiconductor switch, and in series with the first diode D1.

In one example, such as the example illustrated in Fig. 3, in which the inhibiting is performed by both the second diode D2 and the first resistance, the second diode and the first resistance are in parallel with one another.

A flow of current from the first diode D1 into the capacitance may also be at least partially inhibited, hindered, limited, or suppressed. As a result, the rate at which the capacitance is charged may be controlled.

In one example, such as the example illustrated in Fig. 3, the inhibiting is performed by a second resistance, such as resistor R2. The second resistance may be in parallel with the capacitance. The second resistance may be provided by the internal resistance of a device measuring the voltage across the capacitance.

Once the indication of the amount of electrical charge that has flown through the first diode D1 has been determined, a parameter indicative of the rise time $t_{rise}$ of the voltage $v_{CE}$ consequent to the switching event, and/or a parameter indicative of the junction temperature of the switch S1 can be determined. Such a determination can be made by a processor. For example, the determination can be made using calibration data which may be stored in the form of a lookup table. The calibration data may be determined during manufacturing of the circuit 100, as explained below. The monitoring circuitry 200, eg, the processor, may monitor the switch S1 in order to determine when a switching event has occurred. As one possibility, the monitoring circuitry 200 may monitor the voltage applied between the first and second terminals T1 and T2 of the switch S1.

Once those parameter(s) have been determined, action can be taken according to their value(s). Examples of actions that could be taken include turning off the device in which the circuit 100 is housed, activating cooling means to reduce the ambient temperature and/or the junction temperature of the switch S1, or turning off the switch S1 for a period of time. An action can be taken following a determination that at least one of the parameters has exceeded a respective threshold.

The parameter indicative of the junction temperature of the switch S1 can be determined directly from the indication of the amount of electrical charge that has flown through the first diode D1, or may be determined based on the parameter indicative of the rise time $t_{rise}$ of the voltage $v_{CE}$ consequent to the switching event, which is in turn determined based on the amount of electrical charge that has flown through the first diode D1.

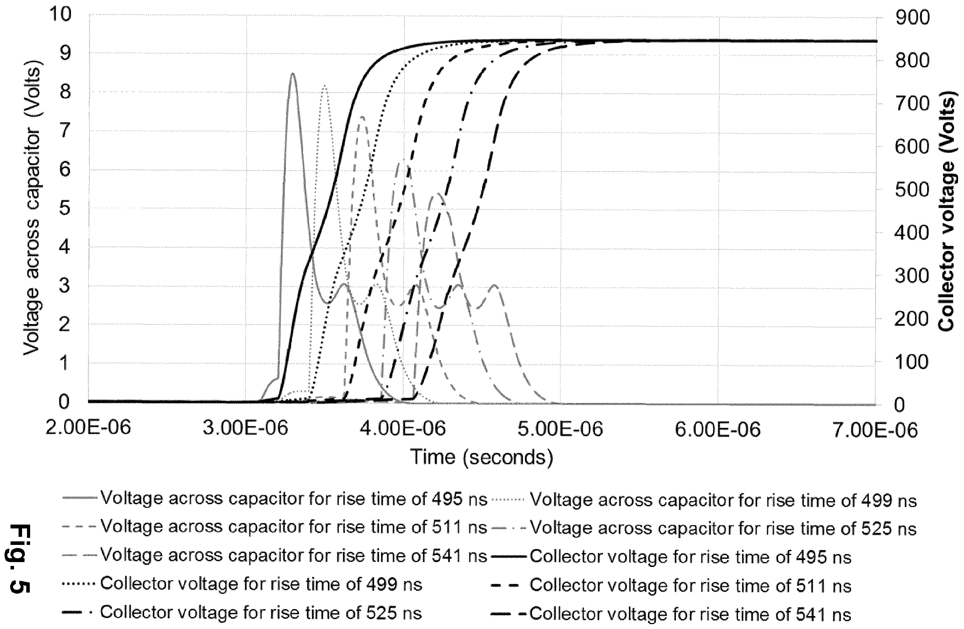

Fig. 5 shows a change in the voltage $v_{CE}$ (in Volts) between the collector terminal and the emitter terminal of the switch S1, and a change in the voltage (in Volts) across the capacitor C1, as a function of time (in seconds) when the switch S1 is turned off. A series of curves are shown for different rise times $t_{rise}$ between 495 and 541 nanoseconds. It can be seen that the peak voltage across the capacitor C1 decreases as the rise time $t_{rise}$ increases.

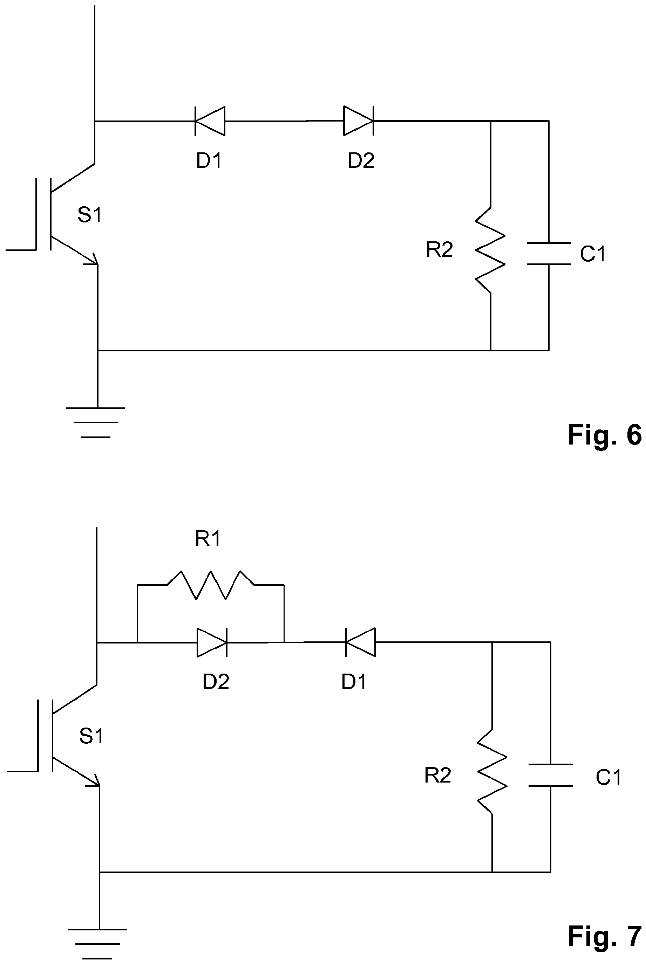

Figs. 6 to 8 show additional examples of the circuit described herein. In Fig. 6, the flow of current from the capacitance towards the third terminal T3 of the semiconductor switch D1 is inhibited by the diode D2, but the second resistor R1, which was present in Fig. 3, is removed. Resistor R2 controls the rate of charge of the capacitor C1, and enables the capacitor C1 to be discharged.

In Fig. 7, the positions of the first and second diodes D1 and D2 are swapped with respect to Fig. 3. The first and second diodes D1 and D2 are still between the third terminal T3 of the switch S1 and the capacitance but, of the two diodes D1 and D2, the second diode D2 is electrically closer to the third terminal T3, rather than the first diode D1 (as in Fig. 3).

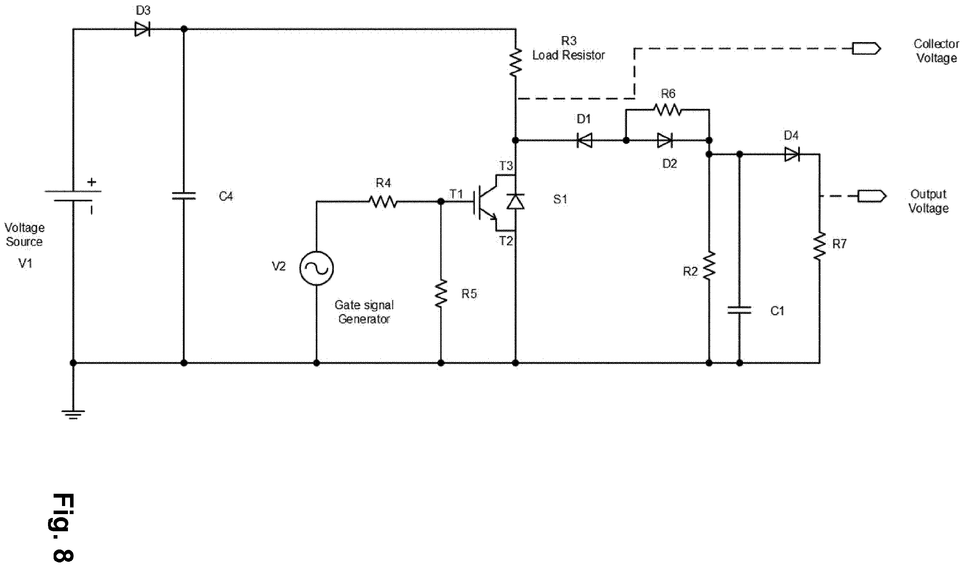

In Fig. 8, the circuit 100 comprises a number of additional components. These components may aid in simulating the performance of the monitoring circuitry 200. In particular, the circuit 100 comprises components for supplying electrical energy to the switch S1, and for controlling the voltage that is applied between the first and second terminals T1 and T2 of the switch S1. The circuit 100 further comprises a third diode D4 and a third resistor R7 for controlling the rate at which capacitor C1 charges. As the second resistor R2 also performs this function, in some examples, resistor R2 may be omitted from the circuit 100.

A person skilled in the art will be aware of a number of types of diodes that could be used as the first and/or second diodes D1 and D2. As one example, a BYT 30P-1000 diode, manufactured by ST Microelectronics, could be used.

The circuit may be fabricated using techniques known to a person skilled in the art. The circuit may be fabricated by assembling the circuit 100, eg, on a printed circuit board.

The calibration data may be determined during manufacturing of the circuit 100. In particular, the circuit 100 may further comprise a memory, and the method may further comprise determining, under a plurality of operating conditions of the circuit, at least two of:

- a respective plurality of parameters each indicative of the rise time $t_{rise}$ of the voltage $v_{CE}$ between the second and third terminals T2 and T3 of the switch S1 consequent to the switching event, or

- a respective plurality of parameters each indicative of the amount of electrical charge that has flown through the first diode D1 consequent to the switching event, or

- a respective plurality of parameters each indicative of the junction temperature of the semiconductor switch S1; and

based on the determining, storing calibration data in the memory.

Determining a respective plurality of parameters each indicative of the junction temperature of the semiconductor switch S1 may comprise using a thermistor or thermocouple to measure the case temperature of the semiconductor switch S1, or to measure the junction temperature of the semiconductor switch S1. Determining a respective plurality of parameters each indicative of the junction temperature of the semiconductor switch S1 may alternatively comprise using an infrared camera to measure the junction temperature of the semiconductor switch S1, eg, when the die of the switch S1 is exposed.

Once the circuit 100 has been fabricated, based on this calibration data, the circuit may, in use, determine the parameter indicative of the rise time $t_{rise}$ of the voltage $v_{CE}$ consequent to the switching event, and/or the parameter indicative of the junction temperature of the switch S1.

Although the present disclosure has been set out principally in relation to IGBTs, the present disclosure applies equally to other types of semiconductor switch.

The present disclosure may be applied to switches used in switched-mode power supplies, uninterruptible power supplies, inverters, variable frequency drives, power conversion products, AC, DC or servo motor drives, DC-DC converters, and electronic switching systems.

An effect of the present disclosure is the innovative use of a diode: its reverse recovery time, generally considered to be a property that it is desirable to reduce as much as possible (ideally to zero), is advantageously used for charging a capacitor. The diode is also used to protect the capacitance, and any device determining the voltage across it, from the high voltage at the third terminal T3 of the switch S1.

An effect of the present disclosure is the accurate estimation of the junction temperature of the switch S1.

An effect of the present disclosure is the provision of a method for measuring the junction temperature of the switch S1 in real time.

An effect of the present disclosure is to obviate the need for a manufacturer of the switch S1 to modify the switch S1 in order to enable the junction temperature to be monitored, ie, an off-the-shelf switch S1 can be used.

An effect of the present disclosure is to enable the switch S1 to perform more reliably.

An alternative to the monitoring circuitry 200 described herein is to use an external thermistor or thermocouple to sense the temperature of the IGBT. However, an effect of the present disclosure is to obviate the need for the monitoring circuitry 200 to be placed in close proximity to the switch S1. A further effect of the present disclosure is to obviate the need for the air that is used to cool the switch S1's heatsink to be isolated from the thermistor or thermocouple in order to prevent that air from cooling the thermistor or thermocouple. A further effect of the present disclosure is to obviate the need for the thermistor or thermocouple to be electrically isolated from a high voltage node (eg, the third terminal T3 of the switch S1) and thermally isolated from any other heat generating source in proximity to the switch S1, which may require a slot in a printed circuit board carrying the circuit 100. A further effect of the present disclosure is to obviate the need for a special mounting arrangement that would need to be incorporated if the thermistor or thermocouple were to be mounted on the switch S1's heatsink. A further effect of the present disclosure is to enable more accurate estimation of the junction temperature of the switch S1, since a thermistor or thermocouple actually measures the *case* temperature of the switch S1, which may differ from the *junction* temperature. A further effect of the present disclosure is to avoid the generation of heat that may be caused by the use of a thermistor and to avoid the associated error in measured temperature: when a current flows through a thermistor, the thermistor will generate heat (self-heating), which will raise the temperature of the thermistor above the temperature of its environment and may thereby introduce a significant error in the temperature that is measured, unless a correction is made.

In the present disclosure, the term switching event may refer to the switch S1 changing state, eg, being turned off, or turned on. The switching event may be defined as beginning when the signal applied to the first terminal T1 of the switch changes enough to change the current that flows between the second and third terminals T2 and T3 of the switch S1. The switching event may be defined as ending when the voltage between the second and third terminals T2 and T3 of the switch S1 reaches a steady state, or may be defined as ending when voltage between the second and third terminals T2 and T3 of the switch S1 reaches a given proportion of its peak value (eg, 50%, 90%, or 100%).

As will be known to a person skilled in the art, a current can result from the flow of positive and/or negative charges. However, it will be understood that, in the present disclosure, when a current or charge is referred to as flowing in a particular direction, as is common in the art, that direction is the direction in which *positive* charges flow, rather than the direction in which charge carriers necessarily flow. The direction of current is therefore defined as the opposite direction to the direction in which electrons, which are *negative* charge carriers, flow.

A skilled person will appreciate that the capacitance may comprise a single capacitor (eg, C1) or may be formed from a plurality of capacitors which may be connected in parallel and/or series. Similarly, a skilled person will appreciate that the resistances (eg, R1 and R2) may each comprise a single resistor or may each be formed from a plurality of resistors which may be connected in parallel and/or series.

A skilled person will understand that the term 'connected' has been used herein to explain the electrical connection of different circuit components.

Those skilled in the art will also recognise that the scope of the invention is not limited by the examples described herein, but is instead defined by the appended claims.

A method is provided that may be performed in the circuit of any of the examples described herein. The method may comprise determining, by the charge determining circuitry, an indication of an amount of electrical charge that has, consequent to a switching event at the semiconductor switch, flown through the first diode under reverse recovery conditions.

A method of fabricating the circuit of any of the examples described herein is provided.

A method of operating a circuit for monitoring a rate of change of a voltage across a switch is provided. The circuit comprises a switch having an input terminal, a first output terminal and a second output terminal; a capacitance having a first terminal and a second terminal; a first diode; and a second diode. The first and second diodes are between the first output terminal of the switch and the first terminal of the capacitance, and the first and second diodes are arranged to be biased in opposite directions. The method comprises causing a change in a voltage between the first and second output terminals of the switch; and, in response to the causing, determining a voltage between across the capacitance.

A method is provided. The method comprises: causing electrical charge to flow from a collector terminal of a switch through a reverse-biased diode; and determining an amount of electrical charge that has flown through the reverse-biased diode.

Examples are set out in the following numbered clauses.

1. A method performed in a circuit,
the circuit comprising:

a semiconductor switch having first, second and third terminals and being arranged such that a signal applied at the first terminal controls a current between the second and third terminals; and

monitoring circuitry comprising a first diode and charge determining circuitry,
the third terminal of the semiconductor switch being connected to the monitoring circuitry and to supply circuitry,
the method comprising:
determining, by the charge determining circuitry, an indication of an amount of electrical charge that has, consequent to a switching event at the semiconductor switch, flown through the first diode under reverse recovery conditions.

2. The method of any preceding clause, wherein the indication of the amount of electrical charge that has flown through the first diode is determined by determining a voltage across a capacitance connected in series with the first diode.

3. The method of clause 2, further comprising:
inhibiting a flow of current from the capacitance towards the third terminal of the semiconductor switch.

4. The method of clause 3, wherein the inhibiting is performed by one or both of:

a second diode between the capacitance and the third terminal of the semiconductor switch and in series with the first diode, and

a first resistance between the capacitance and the third terminal of the semiconductor switch and in series with the first diode.

5. The method of clause 4, wherein the inhibiting is performed by the second diode, and wherein the second diode has a lower voltage rating than the first diode.

6. The method of any of clauses 4 to 5, wherein the inhibiting is performed by both the second diode and the first resistance, the second diode and the first resistance being in parallel with one another.

7. The method of any of clauses 2 to 6, further comprising:
inhibiting a flow of current from the first diode into the capacitance.

8. The method of clause 7, wherein the inhibiting the flow of current from the first diode into the capacitance is performed by a second resistance in parallel with the capacitance.

9. The method of any preceding clause, further comprising:
based on the indication of the amount of electrical charge that has flown through the first diode, determining at least one of:

a parameter indicative of a rise time of a voltage between the second and third terminals of the semiconductor switch consequent to the switching event, or

a parameter indicative of a junction temperature of the semiconductor switch.

10. The method of clause 9, further comprising:
determining that at least one of the at least one parameters has exceeded a respective threshold.

11. The method of any of clauses 9 to 10, comprising determining the parameter indicative of the rise time and the parameter indicative of the junction temperature, wherein the determination of the parameter indicative of the junction temperature is based on the parameter indicative of the rise time.

12. The method of any preceding clause, wherein the semiconductor switch is an insulated-gate bipolar transistor.

13. The method of clause 12, wherein the third terminal of the semiconductor switch is a collector terminal of the transistor.

14. The method of any preceding clause, wherein the switching event comprises the semiconductor switch being switched off.

15. The method of any preceding clause, wherein a reverse recovery time of the first diode is sufficient to allow the electrical charge to flow through the first diode under reverse recovery conditions until at least an end of the switching event.

16. The method of clause 15, wherein the reverse recovery time is substantially equal to a rise time of a voltage between the second and third terminals of the semiconductor switch consequent to the switching event when the semiconductor switch is operated at a junction temperature of 25 degrees Celsius.

17. The method of any of clauses 15 to 16, wherein the end of the switching event comprises a voltage between the second and third terminals of the semiconductor switch reaching a steady state.

18. A circuit arranged to perform the method of any preceding clause.

19. A circuit comprising:

a semiconductor switch having first, second and third terminals and being arranged such that a signal applied at the first terminal controls a current between the second and third terminals; and

monitoring circuitry comprising:

a first diode; and

charge determining circuitry arranged to determine an indication of an amount of electrical charge that has, consequent to a switching event at the semiconductor switch, flown through the first diode under reverse recovery conditions,

wherein the third terminal of the semiconductor switch is connected to the monitoring circuitry and is arranged to be connected to supply circuitry.

20. A method of fabricating the circuit of any of clauses 18 to 19.

21. The method of clause 20, wherein the circuit further comprises a memory, the method further comprising:

determining, under a plurality of operating conditions of the circuit, at least two of:

a respective plurality of parameters each indicative of a rise time of a voltage between the second and third terminals of the semiconductor switch consequent to the switching event, or

a respective plurality of parameters each indicative of the amount of electrical charge that has flown through the first diode, or

a respective plurality of parameters each indicative of a junction temperature of the semiconductor switch; and

based on the determining, storing calibration data in the memory.

22. A circuit or method substantially as described herein and with reference to the accompanying drawings.

**Claims**

1. A method performed in a circuit,
   the circuit comprising:

   a semiconductor switch having first, second and third terminals and being arranged such that a signal applied at the first terminal controls a current between the second and third terminals; and
monitoring circuitry comprising a first diode and charge determining circuitry,
the third terminal of the semiconductor switch being connected to the monitoring circuitry and to supply circuitry,
the method comprising:
determining, by the charge determining circuitry, an indication of an amount of electrical charge that has, consequent to a switching event at the semiconductor switch, flown through the first diode under reverse recovery conditions.

2. The method of claim 1, wherein the indication of the amount of electrical charge that has flown through the first diode is determined by determining a voltage across a capacitance connected in series with the first diode.

3. The method of claim 2, further comprising:
inhibiting a flow of current from the capacitance towards the third terminal of the semiconductor switch.

4. The method of claim 3, wherein the inhibiting is performed by one or both of:

a second diode between the capacitance and the third terminal of the semiconductor switch and in series with the first diode, and
a first resistance between the capacitance and the third terminal of the semiconductor switch and in series with the first diode, optionally wherein the inhibiting is performed by the second diode, and wherein the second diode has a lower voltage rating than the first diode.

5. The method of claim 4, wherein the inhibiting is performed by both the second diode and the first resistance, the second diode and the first resistance being in parallel with one another.

6. The method of any of claims 2 to 5, further comprising:
inhibiting a flow of current from the first diode into the capacitance, optionally wherein the inhibiting of the flow of current from the first diode into the capacitance is performed by a second resistance in parallel with the capacitance.

7. The method of any preceding claim, further comprising:
based on the indication of the amount of electrical charge that has flown through the first diode, determining at least one of:

a parameter indicative of a rise time of a voltage between the second and third terminals of the semiconductor switch consequent to the switching event, or
a parameter indicative of a junction temperature of the semiconductor switch,
the method optionally further comprising:
determining that at least one of the at least one parameters has exceeded a respective threshold.

8. The method of claim 7, comprising determining the parameter indicative of the rise time and the parameter indicative of the junction temperature, wherein the determination of the parameter indicative of the junction temperature is based on the parameter indicative of the rise time.

9. The method of any preceding claim, wherein the semiconductor switch is an insulated-gate bipolar transistor, optionally wherein the third terminal of the semiconductor switch is a collector terminal of the transistor.

10. The method of any preceding claim, wherein the switching event comprises the semiconductor switch being switched off.

11. The method of any preceding claim, wherein a reverse recovery time of the first diode is sufficient to allow the electrical charge to flow through the first diode under reverse recovery conditions until at least an end of the switching event, optionally wherein the reverse recovery time is substantially equal to a rise time of a voltage between the second and third terminals of the semiconductor switch consequent to the switching event when the semiconductor switch is operated at a junction temperature of 25 degrees Celsius.

12. The method of claim 11, wherein the end of the switching event comprises a voltage between the second and third terminals of the semiconductor switch reaching a steady state.

13. A circuit arranged to perform the method of any preceding claim.

14. A method of fabricating the circuit of claim 13.

15. The method of claim 14, wherein the circuit further comprises a memory, the method further comprising:

determining, under a plurality of operating conditions of the circuit, at least two of:

a respective plurality of parameters each indicative of a rise time of a voltage between the second and third terminals of the semiconductor switch consequent to the switching event, or
a respective plurality of parameters each indicative of the amount of electrical charge that has flown through the first diode, or
a respective plurality of parameters each indicative of a junction temperature of the semiconductor switch; and

based on the determining, storing calibration data in the memory.

**Fig. 1**

Supply circuitry
150

Monitoring circuitry
200

Charge
determining
circuitry
250

D1

T3

T1

S1

T2

100

**Fig. 2**

Fig. 3

$$y = 9E\text{-}06x^2 - 0.0341x + 61.443$$

Peak voltage across capacitor (Volts)

Rise time (nanoseconds)

Fig. 4

**Fig. 5**

EP 3 419 171 A1

Legend:

— Voltage across capacitor for rise time of 495 ns ⋯⋯ Voltage across capacitor for rise time of 499 ns
— — Voltage across capacitor for rise time of 511 ns — ⋅ — Voltage across capacitor for rise time of 525 ns
— — Voltage across capacitor for rise time of 541 ns —— Collector voltage for rise time of 495 ns
⋯⋯ Collector voltage for rise time of 499 ns — — Collector voltage for rise time of 511 ns
— ⋅ Collector voltage for rise time of 525 ns — — Collector voltage for rise time of 541 ns

**Fig. 6**

**Fig. 7**

Fig. 8

Europäisches Patentamt
European Patent Office
Office européen des brevets

## EUROPEAN SEARCH REPORT

Application Number

EP 18 17 9338

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/252402 A1 (SINGH BRIJ N [US]) 1 September 2016 (2016-09-01) * paragraph [0031] - paragraph [0039]; figures 1-5 * | 1-15 | INV. H03K17/567 H03K17/082 H03K17/18 |
| A | SUNDARAMOORTHY V ET AL: "Online estimation of IGBT junction temperature (Tj) using gate-emitter voltage (Vge) at turn-off", 2013 15TH EUROPEAN CONFERENCE ON POWER ELECTRONICS AND APPLICATIONS (EPE), IEEE, 2 September 2013 (2013-09-02), pages 1-10, XP032505626, DOI: 10.1109/EPE.2013.6634444 [retrieved on 2013-10-16] * the whole document * | 1-15 | |
| A | DE 10 2012 006009 A1 (VOLKSWAGEN AG [DE]) 26 September 2013 (2013-09-26) * the whole document * | 1-15 | |
| A | WO 2008/132508 A2 (CAMBRIDGE SEMICONDUCTOR LTD [GB]; RYAN PAUL [GB]; JACQUES RUSSELL [GB]) 6 November 2008 (2008-11-06) * the whole document * | 1-15 | TECHNICAL FIELDS SEARCHED (IPC) H03K G01K |

The present search report has been drawn up for all claims

| Place of search | Date of completion of the search | Examiner |
|---|---|---|
| The Hague | 15 October 2018 | João Carlos Silva |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 17 9338

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2018

| Patent document cited in search report | Publication date | Patent family member(s) | Publication date |
|---|---|---|---|
| US 2016252402 A1 | 01-09-2016 | BR 102016004017 A2<br>CN 105928631 A<br>DE 102016201004 A1<br>GB 2537212 A<br>US 2016252402 A1 | 30-08-2016<br>07-09-2016<br>01-09-2016<br>12-10-2016<br>01-09-2016 |
| DE 102012006009 A1 | 26-09-2013 | NONE | |
| WO 2008132508 A2 | 06-11-2008 | GB 2448759 A<br>WO 2008132508 A2 | 29-10-2008<br>06-11-2008 |

For more details about this annex : see Official Journal of the European Patent Office, No. 12/82